# EUROPEAN PATENT SPECIFICATION

(11) **EP 2 962 536 B1**
(45) Date of publication and mention of the grant of the patent: **02.05.2018**
(21) Application number: 14709398.3
(22) Date of filing: 03.03.2014
(51) Int. Cl.: H05K 7/20

(54) **COOLING SYSTEM WITH REDUNDANCY**
KÜHLSYSTEM MIT REDUNDANZ
SYSTÈME DE REFROIDISSEMENT À REDONDANCE

(30) Priority: 01.03.2013 GB 201303643
(43) Date of publication of application: 06.01.2016
(73) Proprietor: Iceotope Limited, Guernsey GY1 3HB (GB)
(72) Inventor: BENT, Jason, Ellesmere Shropshire SY12 9AW (GB); DEAKIN, Keith, Sheffield South Yorkshire S2 4TE (GB); HOPTON, Peter, Whitwell Worksop S804TB (GB)
(74) Representative: Boult Wade Tennant
(86) International application number: PCT/GB2014/050616
(87) International publication number: WO 2014/132086

(56) References cited:
- WO-A2-2010/130993
- GB-A- 1 201 297
- US-A1- 2013 021 752
- US-B1- 6 213 194
- US-B2- 6 796 372

## Description

### Technical Field of the Invention

The invention concerns a cooling apparatus or cooling system and methods of operating or manufacturing such a cooling apparatus or cooling system.

### Background to the Invention

Electronic components and in particular computer processors generate heat in operation, which can lead to overheating and consequent damage to the component and other parts of the system. It is therefore desirable to cool the component to transfer the heat away from it and maintain the component temperature no higher than the maximum operating temperature that is specified for correct and reliable operation of the component.

This issue especially concerns data processing of computer server centres, where a substantial number of computer processors are co-located and intended for reliable, continuous operation over a long time period. These centres may typically contain many server units, occupying multiple equipment racks and filling one or more rooms. Each server unit contains one or more server boards. A single server board can consume many of hundreds of watts of electrical power, much of which is dissipated as heat.

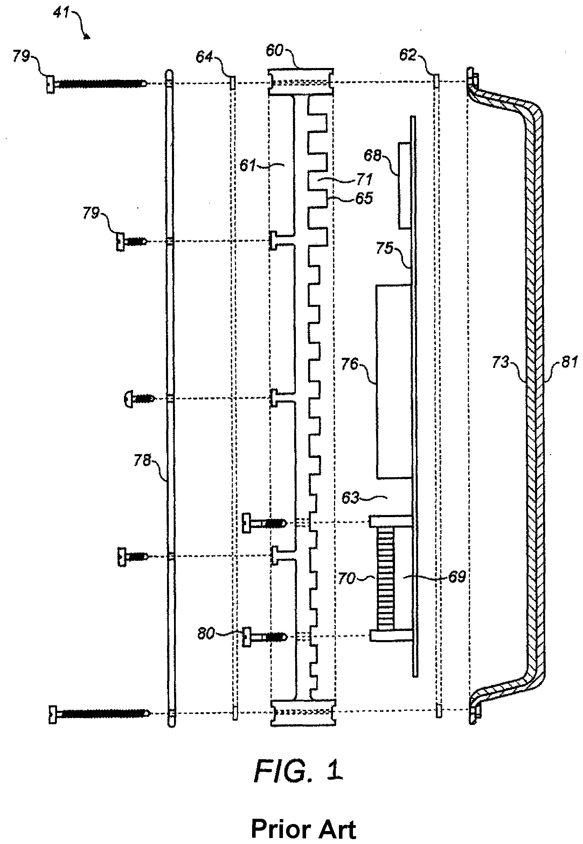

International patent application number WO-2010/130993 and US patent publication number 2010/0290190 (both having inventorship in common with this invention) describe a cooling device that uses a sealable module for containing the heat generating electronic component or components. Referring to Figure 1, there is shown a cross-sectional exploded view of a sealable module comprising a heat generating electronic component as described in these documents.

The sealable module comprises: a housing 81; a finned conduction surface 71 (having pin-fin projections 65) forming part of a cold plate 60; a container volume, defined after assembly of the components by the housing 81 and conduction surface 71 and filled with a first cooling liquid (not shown); liquid flow channels 61 adjacent the conduction surface 71; small electronic component 68; large electronic component 69; and memory module 76.

The sealable module further comprises: an electronic circuit board 75; mounting pillars 63 for the electronic circuit board 75; a component heat sink 70 attached to the large electronic component 69; screws 80 to attach the mounting pillars 63 to the conduction surface 71; a cover plate 78 for the side of the cold plate opposite to that of the finned conduction surface; insulation 73 for the housing 81; first sealing gasket 62; second sealing gasket 64; and screws 79 to hold the components of the cold plate assembly together. The insulation 73 can also serve as a protective membrane between the housing 81 and the circuit board 75.

Once all of the screws are in place and the various components affixed as shown, the internal volume defined by the conduction surface 71 and the housing 81 is filled with a coolant liquid. In operation, heat is generated by the components 68, 69 and memory module 76 on the circuit board 75. This is transferred to the cooling liquid, initially by local conduction and then, as the heat liquid expands and becomes buoyant, by convection. The convecting liquid quickly comes into contact with the fins 65 and other surfaces of the conduction surface 71.

Heat from the fins 65 for the conduction surface 71 is conducted to the circulating second liquid (not shown) that flows via channels 61, so as to cool the conduction surface 71 and thus the cooling liquid. In this arrangement, the flow of the second coolant liquid within the channels 61 can be controlled to ensure that the coolant liquid within the volume defined by the conduction surface 71 and housing 81 remains within a desired temperature range. In particular, boiling of the first coolant liquid can be avoided.

This is an efficient, robust and flexible form of cooling for electronic components. In contrast with earlier designs for cooling of electronic components, the pressures and temperatures within the system can be readily controlled and expensive and complex refrigeration technology is not necessary.

Improving this configuration for more complex cooling systems is a challenge. In particular, data processing or computer server centres use electronic components with increasing greater heat output, requiring more cooling power than before. At the same time, redundancy is added to the cooling system to avoid failures of specific components or processes causing a breakdown of a portion or the whole of the system. Adding such redundancy increase costs and can reduce overall efficiency.

US-2013/021752 describes a cooling apparatuses for fluid immersion-cooling of an electronic component. US-6,213,194 uses a DC motor together with a hot gas bypass valve for removing heat from a computer system. The cooling system is modular and is can be added to or removed from a redundant system which includes a single evaporator with multiple refrigerant loops.

### Summary of the Invention

Against this background, the present invention provides a cooling apparatus in accordance with claim 1. Such an apparatus comprises: an interfacing component configured to receive an electronic device and defining a thermal interface through which heat generated by the electronic device can be transferred away from it; a heat exchanger arrangement, coupled to the thermal interface and
configured to transfer heat generated by the electronic device via the thermal interface to a first heat sink and a second heat sink. The first and second heat sinks are isolated from one another (preferably within the heat exchanger arrangement). Ideally, the thermal interface is convective. Advantageously, it allows heat generated by the electronic device to be transferred away from it via an inner coolant. Subsequent references to the coolant may refer to this inner coolant. Thus, redundancy is provided at the level of a module, which may be a single container or mounting used for cooling one or more components. Each component may be a single electronic component or it may be a device comprising a plurality of electronic components (such as a circuit board) or a plurality of such devices.

Advantageously, in the event that a part of the heat exchanger arrangement is unable to transfer heat to the first heat sink, the heat exchanger arrangement is configured to transfer at least some (or all) of the heat that would have been transferred to the first heat sink to the second heat sink. Thus, if the part of the heat exchanger arrangement transferring heat to one heat sink fails, the heat exchanger arrangement may be configured to transfer a greater proportion of heat to the other heat sink. This may act to provide redundancy.

Beneficially, the heat exchanger arrangement comprises: a first coolant connector (or port), for receiving a first outer coolant as part of the first heat sink. Advantageously, the heat exchanger arrangement further comprises: a second coolant connector (or port), for receiving a second outer coolant as part of the second heat sink. Thus, the heat exchanger arrangement provides connectors for interfacing the apparatus (especially in the form of a module) as part of a cooling system. This may allow multiple apparatus to share first and/or second outer coolants. This may allow a modular system to be constructed in which each module has redundancy, but still allowing multiple modules to share outer coolant and thereby improve efficiency. Also, such modules can be used in a wide range of different environments. The first coolant connector may comprise a first coolant inlet connector for receiving the first outer coolant and a first coolant outlet connector for carrying the first outer coolant after heat has been transferred to it from the electronic device. Similarly, the second coolant connector may comprise a second coolant inlet connector for receiving the second outer coolant and a second coolant outlet connector for carrying the second outer coolant after heat has been transferred to it from the electronic device.

In some embodiments, the heat exchanger arrangement is configured to transfer an approximately equal proportion of the heat received from the electronic device to the first heat sink as the second heat sink. In other words, the heat exchanger arrangement may divide the heat output between the two heat sinks roughly equally, such that the two share the load. However, the ratio of heat transfer may be controlled or may be set differently (for example, 45%:65%, 40%:60%, 35%:75%, 30%:70%, 25%:75%, 20%:80%, 10%:90%, 5%:95%). The capacity of the first heat sink and the second heat sink may be the same in many embodiments.

Preferably, the heat exchanger arrangement or the interfacing component comprises at least one conduction surface, configured to transfer heat generated by the electronic device via the convective thermal interface to the first heat sink and the second heat sink. The use of a conduction surface or conduction surfaces (which may be termed a cold plate) allows heat transfer across a surface, which may be more efficient than other forms of heat exchanger.

The interfacing component comprises a housing that defines at least part of a volume in which a coolant and at least part of the electronic device can be located (and preferably confined, for example by sealing the volume), such that the coolant can provide the thermal interface by convection. The heat exchanger arrangement may then comprise: a first heat exchanger, having a part located in a first part of the volume and configured to transfer heat from a first portion of the coolant to the first heat sink; and a second heat exchanger, having a part located in a second part of the volume and arranged in parallel with the first heat exchanger, the second heat exchanger being configured to transfer heat from a second portion of the coolant to the second heat sink.

Thus, a sealable module that is similar to the module shown in Figure 1 may be provided, but with a second, parallel heat exchanger. This parallel heat exchanger provides redundancy, allowing cooling to continue even if the first heat exchanger fails for any reason. Moreover, it increases the efficiency of cooling.

Preferably, the first heat exchanger comprises a first conduction surface that cooperates with the housing so as to define at least part of the volume. In other words, the sealable module may be formed as a container, a part of the container walls being defined by the housing and another part of the container walls being defined by the first conduction surface.

In the preferred embodiment, the first heat exchanger further defines a first channel for receiving a first outer (liquid) coolant (this is preferably the first outer coolant from the first coolant connector). Then, the first conduction surface may separate the volume and the first channel to allow conduction of heat between the volume and the first channel through the first conduction surface. Thus, the first heat sink is provided by the first outer coolant that carries heat from the inner liquid coolant within the volume away from the sealable module via conduction through the first conduction surface.

Advantageously, the cooling apparatus further comprises the electronic device. Then, at least a portion of the first conduction surface or housing may be shaped in conformity with the shape of the electronic device. This conformity of shape may further improve efficiency.

The second heat exchanger may be formed in a similar way to the first heat exchanger. Thus, the second heat exchanger may comprise a second conduction surface that cooperates with the housing (and optionally, the first conduction surface) so as to define at least part of the volume. Then, the second heat exchanger may further define a second channel for receiving a second outer (liquid) coolant (which may be the second outer coolant from the second coolant connector). In this case, the second conduction surface may separate the volume and a second channel to allow conduction of heat between the volume and second channel through the second conduction surface. In this way, the first and second outer liquid coolants may be isolated from one another. This may achieve the isolation of the first and second heat sinks. Advantageously, this may also improve the flexibility, efficiency and robustness of the first and second heat exchangers.

Where the cooling apparatus comprises the electronic device, at least a portion of the second conduction surface or housing is optionally shaped in conformity with a shape of the electronic device. This may depend on the configuration of the component or components, but also on the configuration of the first and second heat exchangers and particularly the first and second conduction surfaces.

The electronic device may take a large number of different forms. In the preferred embodiment, the electronic device comprises a circuit board. This may then define a substantially planar form for the electronic device.

Whether or not the electronic device is planar, it may have an axis of elongation. This especially applies when the electronic device comprises a circuit board, but it can also be the case where the electronic device is a discrete package or a combination of discrete packages not mounted on a circuit board. While the electronic device has an axis of elongation, the first conduction surface may have a respective axis of elongation that is substantially parallel to the axis of elongation of the at least one electronic component. Additionally or alternatively, the second conduction surface may have an axis of elongation that is substantially parallel to the axis of elongation of the at least one electronic component. In the preferred embodiment, both the first and second conduction surfaces have parallel axes of elongation.

The first conduction surface may have a substantially planar form. Additionally or alternatively, the second conduction surface may have a substantially planar form. Where the electronic device and the first conduction surface both have a substantially planar form, the planes of the first conduction surface may be substantially parallel to the plane of the electronic device. Additionally or alternatively, the electronic device and the second conduction surface may both have a substantially planar form and the plane of the second conduction surface may be substantially parallel to the plane of the electronic device.

In some embodiments, the housing and the first and second conduction surfaces define the volume. Thus, a container with integrated heat exchangers can be provided. Optionally, the housing, the first and second conduction surfaces and the electronic device define the volume. Then, the electronic device itself forms an integral part of the module outer container. In particular, the volume may further comprises a wicking material such that a vapour chamber is formed.

The (inner) coolant comprises a liquid (defined at standard or operating temperature and pressure). In embodiments, the cooling apparatus further comprises the (inner) coolant. Advantageously, the first outer coolant comprises a liquid. Additionally or alternatively, the second outer coolant comprises a liquid.

Where the heat exchanger arrangement or the interfacing component comprises a conduction surface, the heat exchanger arrangement may further comprise: a first piping system, arranged to carry a first coolant (preferably, the first outer coolant from the first coolant connector), to receive heat directly from the conduction surface and to transfer heat through the conduction surface to the first (outer) coolant; and a second piping system, arranged in parallel with the first piping system to carry a second coolant (preferably, the second outer coolant from the second coolant connector), to receive heat directly from the conduction surface and to transfer heat through the conduction surface to the second (outer) coolant. The first and second (outer) coolants are preferably isolated from one another, at least within the heat exchanger arrangement. In these embodiments, the heat exchanger arrangement may be provided by a single cold plate with multiple coolant channels, each of which is isolated from the others. This provides redundancy by use of a single heat exchanger (the cold plate), whilst still providing two separate heat sinks.

In the preferred embodiment, the first piping system and second piping system are arranged in parallel in a three-dimensional crossing arrangement, such as in a helical arrangement. In other words, the two channels cross (or spiral) to receive roughly equal proportions of the heat and avoid placing too great a load on one heat sink under normal operation. In less preferred embodiments, the interfacing component comprises the conduction surface that is configured for attachment to the electronic device, such that the thermal interface is provided by conduction. Thus, the cold plate may be affixed directly to a surface of the electronic device (such as a circuit board). Some thermally conductive material may interpose between the electronic device and the conduction surface, although the conduction surface is still physically attached to the electronic device through this material.

In preferred embodiments, the interfacing component comprises a housing that defines at least part of a volume in which a third coolant and at least part of the electronic device can be located. This may mean that the third coolant can provide the thermal interface by convection to the conduction surface that forms part of the heat exchanger arrangement. Then, the third coolant may be isolated from the first and second coolants.

In another aspect, there may be provided a cooling system comprising at least one cooling apparatus as described herein. The cooling system may further comprise: a piping system, configured to carry the respective first outer coolant to each (first coolant connector) of the at least one cooling apparatus for acting as the first heat sink of the first heat exchanger arrangement and to carry the respective second outer coolant to each (first coolant connector) of the at least one cooling apparatus for acting as the second heat sink of the heat exchanger arrangement. Then, for each of the at least one cooling apparatus, the respective first and second outer coolants may be isolated from one another. Separate pumps may be provided for each of the first and second outer coolants. In embodiments, for each of the at least one cooling apparatus, the piping system may be configured to combine the respective first and second outer coolants. Multiple pumps may provided in this case for redundancy. In some embodiments, the cooling system further comprises a mounting portion for receiving the at least one cooling apparatus for interfacing with the piping system. The cooling system may be in the form of a unit, rack, cabinet or some other housing structure.

The piping system may be configured to allow multiple modules to be connected with a series or parallel connection (or combination of the two) to share the first outer coolant, second outer coolant or both. This may use the first and second coolant connectors in advantageous ways. For example, the at least one cooling apparatus may comprise a plurality of cooling apparatus, each cooling apparatus being as described herein. Then the first and second outer coolants may be shared between each of the plurality of cooling apparatus. In some embodiments of such cases, the piping system may be configured to carry the first outer coolant to the respective first coolant connector of each of the plurality of cooling apparatus in series. Additionally or alternatively, the piping system may be further configured to carry the second outer coolant to the respective second coolant connector of each of the plurality of cooling apparatus in series. In some embodiments of such cases, the piping system may be configured to carry the first outer coolant to the respective first coolant connector of each of the plurality of cooling apparatus in parallel. Additionally or alternatively, the piping system may be further configured to carry the second outer coolant to the respective second coolant connector of each of the plurality of cooling apparatus in parallel.

Advantageously, the cooling system may further comprise a second heat exchanger arrangement, configured to receive a first outer coolant (preferably, the respective first outer coolant from each of the at least one cooling apparatus) and a second outer coolant (preferably, the respective second outer coolant from each of the at least one cooling apparatus). Then, the second heat exchanger arrangement may be configured to transfer heat from the first and second outer coolants to a common output heat sink. This may be used for outer coolants from each cooling apparatus individually or it may be applied when multiple cooling apparatus are connected together to share outer coolants. The second heat exchanging arrangement may comprise one or more than one heat exchanger. It will therefore be understood that the first and second heat sinks of the first and second heat exchangers are isolated from one another (at least within the heat exchanger arrangement of each cooling apparatus), but these two heat sinks may have their own heat sinks and these heat sinks need not be isolated from one another.

In a further aspect, the present invention may be found in a method of operating a cooling system in line with claim 15. Such a method comprises: coupling an electronic device to an interfacing component that defines a thermal interface through which heat generated by the electronic device can be transferred away from it; operating the electronic device to generate heat that is transferred to the thermal interface; receiving heat generated by the electronic device at a heat exchanger arrangement via the thermal interface; and transferring heat received at the heat exchanger arrangement to a first heat sink and a second heat sink. The first and second heat sinks are isolated from one another (at least within the heat exchanger arrangement). Preferably, the thermal interface is convective. In that case, the convective thermal interface allows heat generated by the electronic device to be can be transferred away from it via an inner coolant. Beneficially, the method further comprises: receiving a first outer coolant as part of a first heat sink at a first coolant connector. Advantageously, the method further comprises: receiving a second outer coolant as part of the second heat sink at a second coolant connector.

It will be understood that method features corresponding with the structural, apparatus features described herein may optionally be provided in conjunction with the method. Some of these are now explicitly defined below.

In the event that a part of the heat exchanger arrangement is unable to transfer heat to the first heat sink, the method may further comprise transferring at least some of the heat that would have been transferred to the first heat sink to the second heat sink. Optionally, the step of transferring heat comprises transferring an approximately equal proportion of the heat received from the electronic device to the first heat sink as the second heat sink.

The interfacing component comprises a housing that defines at least part of a volume. Then, the step of coupling may comprise locating at least part of the electronic component in the volume together with a coolant (the inner coolant), such that the coolant can provide the thermal interface by convection. Here, the step of receiving heat may comprise: receiving a first portion of the (inner and/or liquid) coolant at a first heat exchanger located in a first part of the volume, so as to transfer heat from the first portion of the coolant to the first heat sink; and receiving a second, separate portion of the (inner and/or liquid) coolant at a second heat exchanger arranged in parallel with the first heat exchanger and located in a second part of the volume, so as to transfer heat from the second portion of the coolant to the second heat sink.

The step of receiving the first portion of the coolant at the first heat exchanger may comprise transferring heat received from the first portion of the coolant to a first outer coolant. Additionally or alternatively, the step of receiving the second portion of the liquid coolant at the second heat exchanger may comprise transferring heat received from the second portion of the liquid coolant to a second outer coolant. Where the first and second outer coolants are used, these may be isolated from one another, at least within the heat exchanger arrangement. Advantageously, the first and second outer coolants are liquids.

In some embodiments, the method may further comprise: combining the first and second outer coolants outside the heat exchanger arrangement. Alternatively, the first and second outer coolants may remain isolated outside the heat exchanger arrangement.

The method may further comprise: receiving the first and second outer coolants from the heat exchanger arrangement at a second heat exchanger arrangement; and transferring heat from the first and second outer coolants to a common output heat sink using the second heat exchanger arrangement.

In a yet further aspect, there may be a method of manufacturing a cooling system, comprising: coupling an electronic device to an interfacing component that defines a thermal interface through which heat generated by the electronic device can be transferred away from it; mounting a heat exchanger arrangement on the interfacing component in order to transfer heat from the electronic device to the heat exchanger arrangement via the thermal interface; and configuring the heat exchanger arrangement so as to transfer heat received from the electronic device to a first heat sink and a second heat sink. The first and second heat sinks are isolated from one another. Optionally, the method may further comprise filling the volume with the cooling liquid.

Again, it will be understood that this method may comprise optional method steps corresponding with any one or more of the apparatus features defined herein.

The step of coupling may comprise housing the electronic device in a volume defined by a sealable module, such that a liquid coolant may be added to the volume for removing heat generated by the electronic device. Then, the step of mounting the heat exchanger arrangement may comprise: mounting a first heat exchanger in a first part of the volume so that it can receive a first portion of the liquid coolant and transfer heat from the first portion of the liquid coolant to a first heat sink; and mounting a second heat exchanger in parallel with the first heat exchanger in a second part of the volume so that it can receive a second, separate portion of the liquid coolant and transfer heat from the second portion of the liquid coolant to a second heat sink. Optionally, the method may further comprise filling the volume with the cooling liquid.

The combination of any of the apparatus or method features described herein or both is also provided even if not explicitly disclosed.

### Brief Description of the Drawings

The invention may be put into practice in various ways, one of which will now be described by way of example only and with reference to the accompanying drawings in which:
Figure 1 is a cross-sectional exploded view of a sealable module comprising a heat generating electronic component in accordance with an existing configuration;
Figure 2 is a schematic diagram of a cooling apparatus in accordance with a first embodiment of the present invention;
Figure 3 is a cross-sectional exploded view of an embodiment of a sealable module comprising a heat generating electronic component in accordance with the schematic diagram of Figure 2;
Figure 4 is a schematic diagram of a cooling apparatus in accordance with a second embodiment of the present invention;
Figure 5 is a schematic diagram of a cooling apparatus in accordance with a third embodiment of the present invention; and
Figure 6 is a schematic diagram of a cooling apparatus in accordance with a fourth embodiment, which may be ancillary to the present invention.

### Detailed Description of a Preferred Embodiment

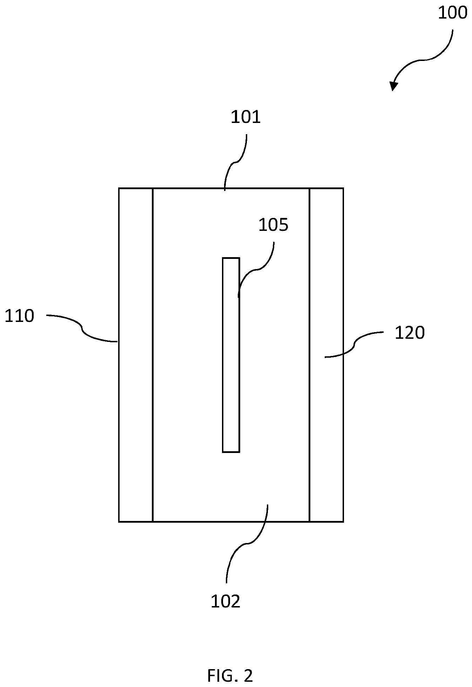

Referring to Figure 2, there is shown a cooling apparatus 100, comprising a housing 101; a heat generating electronic component 105; a first heat exchanger 110; and a second heat exchanger 120. The housing 101 (optionally in conjunction with the first heat exchanger 110, second heat exchanger 120 or both) defines a volume 102, in which the heat generating electronic component 105 is located.

Prior to operation, the volume 102 is filled with a liquid coolant. WO-2010/130993 and US-2010/0290190 describe techniques for filling a volume such as volume 102 with liquid coolant, in particular accounting for any pressure changes during operation. The sealable module 100 is sealed such that the liquid coolant should not escape.

During operation, the heat generating electronic component 105 heats the liquid coolant in the volume 102 and heat is transferred from the liquid coolant to heat sinks exterior the sealable module 100 via the first heat exchanger 110 and the second heat exchanger 120. The respective heat sinks for the first and second heat exchangers are isolated from another. In this context, the term heat sink is used simply as a shorthand for the device or arrangement through which heat is transferred away from the sealable module 100.

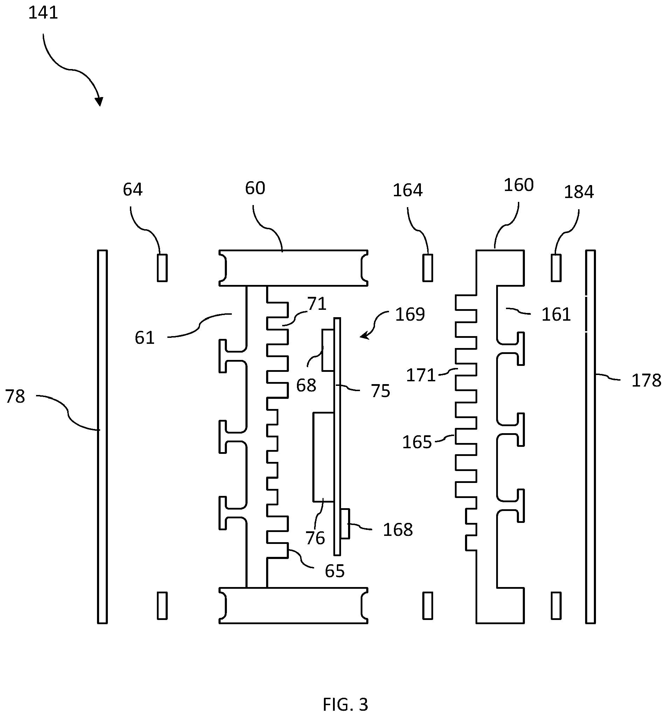

Implementation details of one embodiment in accordance with Figure 2 are now discussed. In that context and with reference to Figure 3, there is shown a cross-sectional exploded view of an embodiment of a sealable module comprising a heat generating electronic component in accordance with Figure 2. This embodiment is largely based on the existing design shown in Figure 1. Where the same components or parts as shown in Figure 1 are used, identical reference numerals have been employed.

The sealable module 141 comprises a heat generating electronic component 169. It further comprises: a first finned conduction surface 71 forming part of a first cold plate 60; first liquid flow channels 61 adjacent the conduction surface 71; a second finned conduction surface 171 forming part of a second cold plate 160; and second liquid flow channels 161 adjacent the second conduction surface 171. Fixings are omitted from this drawing, for the sake of clarity.

As per Figure 1, the heat generating electronic component 169 comprises: a circuit board 75; a small electronic component 68; a large electronic component 76; and a rear-mounted electronic component 168.

The sealable module 141 further comprises: a first sealing gasket 64; a second sealing gasket 164; a third sealing gasket 184; pin-fin projections 65 on the first conduction surface 71; pin-fin projections 165 on the second conduction surface 171; a first cover plate 78 for the side of the first cold plate 60 opposite to the fins on the first conduction surface 71; and a second cover plate 178 for the side of the second plate 170 opposite to the fins on the second conduction surface 171.

Each of the first cold plates 60 and second cold plates 160 are fabricated with two faces, each with a separate function. The first conduction surface 71 and the second conduction surface 171 are a pin-finned plate, forming one face of the respective cold plate. The two cold plates may be attached together, as shown in the drawing, in order to create a sealed volume in which the heat generating electronic component 169 may be housed. The sealing gaskets ensure that the assembled capsule is substantially sealed against liquid loss or ingress of air. Mounting fixtures (not shown) are provided for the heat generating electronic component 169. The fins 65 of the first conduction surface 71 and fins 165 of the second conduction surface 171 face the circuit board 75. In some cases, components of significant size may be present on both sides of the board, as shown. Alternatively (but not as shown), components of significant size may only be present on one side of the board. A small gap is provided between the ends of the fins 65 and the ends of fins 165 and the components. The fins have an elongated cross-section and their height varied, so as to maintain a small gap between the variously sized components on the electronic circuit board and the tops of the fins. This is shown for both fins 65 and fins 165 in Figure 3.

For the first cold plate 60, the first cover plate 78 allows first channels 61 to be defined. These allow liquid flow for a second liquid coolant (distinct from the liquid coolant within the volume defined by the sealed module), which is used for heat transfer away from the sealable module 141. Similarly, the second cover plate 178 creates second channels 161 for a third liquid coolant to flow and thereby convey heat away from the sealable module 141 through an independent path. The second and third liquid coolants are independently controlled, so as to provide two isolated heat sinks for the sealable module 141.

Further design and implementation features of this embodiment may be added or adjusted in accordance with the details disclosed previously published WO-2010/130993 and US-2010/0290190.

Although a specific embodiment of the invention has now been described, the skilled person will understand that various variations and modifications may be made without departing from the scope of the invention. For example, although the embodiment shown in Figure 3 uses two separate cold plates, other types of heat exchangers can be employed. Similarly, whilst there will be understandable advantages from the construction shown in Figure 3, in which the two heat exchangers are provided on opposite walls of the sealable module, it will be understood that the heat exchangers may alternatively be implemented in the same wall, or adjacent walls. An embodiment along these lines is described below. Equivalently, it will be understood that each heat exchanger need not take up the whole of a wall of the sealable module, but could form part of a wall. In fact, more than two heat exchangers might be provided in some embodiments.

With reference to Figure 3, the first conduction surface 71, second conduction surface 171 or both need not be provided with fins 65 or fins 165, and alternatives that would be well known to the skilled person are also possible. Moreover, the fins on one or both conduction surfaces need not have shapes, sizes or both that are adapted in accordance with a shape of the electronic component.

Although a housing that is separate from the first cold plate 60 and second plate 160 is not shown in Figure 3, it will be understood that this is possible as well as various other structural configurations involving cold plates and integrated or distinct housings. Whilst the heat sink for the first heat exchanger and heat sink for the second heat exchanger take the form of liquid coolants in the embodiment in shown in Figure 3, it will be appreciated that other kinds of heat sinks may be used.

Further alternative embodiments are now briefly described at a schematic level. The skilled person will appreciate that further implementation details of such embodiments may be similar to the embodiment described above or similar to other existing arrangements.

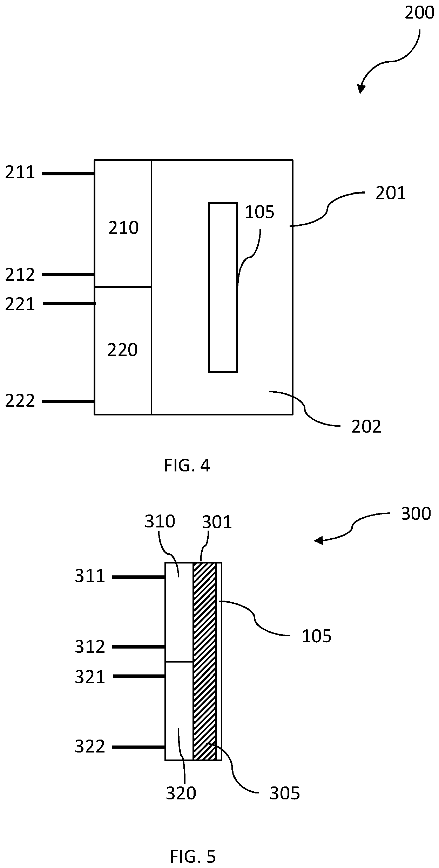

Referring to Figure 4, there is shown a schematic diagram of a cooling apparatus in accordance with a second embodiment of the present invention. Where the same features are shown as in other drawings, the same reference numerals have been used. The cooling apparatus 200 comprises: a housing 201; a heat generating electronic component 105; a first heat exchanger 210; and a second heat exchanger 220. The volume defined by the housing 201, a first heat exchanger 210 and a second heat exchanger 220 is filled with a liquid coolant 202. The first heat exchanger 210 has a coolant input 211 and a coolant output 212 and the second heat exchanger 220 has a coolant input 221 and a coolant output 222, separate from those of the first heat exchanger 210.

This cooling apparatus 200 operates in a similar fashion to the cooling apparatus 100 shown in Figure 2. During operation, the heat generating electronic component 105 heats the liquid coolant in the volume 202 and heat is transferred from the liquid coolant to heat sinks exterior the sealable module 200 via the first heat exchanger 210 and the second heat exchanger 220. The respective heat sinks for the first and second heat exchangers are isolated from another. The first heat exchanger 210 and the second heat exchanger 220 are arranged on the same side of the heat generating electronic component 105 and make up part of the same wall of the volume that they define together with the housing.

Referring next to Figure 5, there is shown a schematic diagram of a cooling apparatus in accordance with a third embodiment of the present invention. Again, the same features as shown in other drawings are indicated by identical reference numerals. The cooling apparatus 300 comprises: a heat generating electronic component 105; a first heat exchanger 310; a second heat exchanger 320; a housing 301; and a wicking material 305. The housing 301 and the wicking material 305 together define a vapour chamber attached to the heat generating electronic component 105.

The first heat exchanger 310 has a coolant input 311 and a coolant output 312 and the second heat exchanger 320 has a coolant input 321 and a coolant output 322, separate from those of the first heat exchanger 310. Thus, the first heat exchanger 310 and the second heat exchanger 320 (which are typically separate cold plates) act in parallel and each can provide redundancy should the other fail.

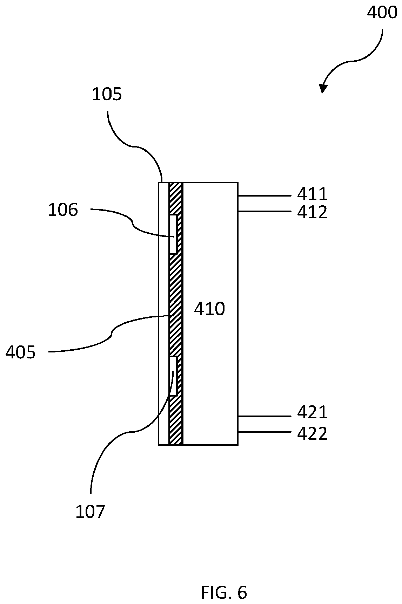

Referring now to Figure 6, there is shown a schematic diagram of a cooling apparatus in accordance with a fourth embodiment, which may ancillary to the present invention. Once more, where the same features are shown as in other drawings, these are indicated by identical reference numerals. The cooling apparatus 400 comprises: a heat generating electronic component 105; a conductive fixing material 405; and a heat exchanger 410. The heat generating electronic component 105 has raised parts (for example, where the heat generating electronic component 105 is a circuit board, it may have components mounted upon it) comprising: a first component 106 and a second component 107. The conductive fixing material 405 is a bonding material which also acts as a thermal interface to conduct heat from the heat generating electronic component 105 to the heat exchanger 410.

The heat exchanger 410 differs from previously described heat exchangers. It is a cold plate with two separate coolant inlets: first inlet 411 and second inlet 412. It also has two separate coolant outlets: first outlet 421 and second outlet 422. Within heat exchanger 410, there are two separate, isolate channels through which two separate flows of coolant are defined: a first flow from first inlet 411 to first outlet 421; and a second flow from second inlet 412 to second outlet 422. These two flows are isolated from one another and therefore act as two parallel heat sinks for the heat exchanger 410. This provides redundancy, such that failure of one flow can be compensated by the other. In order for the transfer of heat from the heat generating electronic component 105 to the two coolant channels to be balanced (and avoid placing a much greater load on one channel than the other), the two channels may be provided to cross over one another in three dimensions, such as using a helical (or spiral) form. The two channels may thereby cover the entire surface of the heat exchanger 410 adjacent the heat generating electronic component 105 (referred to as the conduction surface above) Without such adaptations, a situation may arise if one channel fails that the other channel may not have sufficient thermal capacity to cope with the heat transfer required across the whole heat transfer surface.

Although this embodiment has been described with a conductive thermal interface between the heat generating electronic component 105 and the heat exchanger 410, it will be recognised that it can equally be implemented with a convective thermal interface. This might be implemented by use of a coolant-filled volume, as described with reference to Figures 2 to 4. Also, it will be understood that individual features from the different embodiments can also be combined as appropriate to gain advantage from the specific benefits discussed above.

## Claims

1. A cooling apparatus (100) in the form of a module, comprising:
an interfacing component configured to receive an electronic device and defining a convective thermal interface through which heat generated by the electronic device can be transferred away from it via an inner coolant, the inner coolant comprising a liquid and the interfacing component comprising a housing (101) that defines at least part of a volume (102) in which at least part of the electronic device can be confined and which is filled by the inner coolant, such that the inner coolant provides the convective thermal interface;
**characterized by**
a heat exchanger arrangement (110, 120), coupled to the convective thermal interface and configured to transfer heat generated by the electronic device via the convective thermal interface to a first heat sink and a second heat sink, the first and second heat sinks being isolated from one another within the heat exchanger arrangement, such that in the event that a part of the heat exchanger arrangement is unable to transfer heat to the first heat sink, the heat exchanger arrangement is configured to transfer at least some of the heat that would have been transferred to the first heat sink to the second heat sink; and
wherein the heat exchanger arrangement comprises: a first coolant connector, for receiving a first outer coolant as part of the first heat sink; and a second coolant connector, for receiving a second outer coolant as part of the second heat sink, the first and second coolant connectors being configured to interface the module as part of a cooling system.

2. The cooling apparatus of claim 1, wherein the heat exchanger arrangement or the interfacing component comprises at least one conduction surface (71), configured to transfer heat generated by the electronic device via the convective thermal interface to the first heat sink and the second heat sink.

3. The cooling apparatus of claim 1 or claim 2, wherein the heat exchanger arrangement comprises:
a first heat exchanger (110), having a part located in a first part of the volume and configured to transfer heat from a first portion of the inner coolant to the first heat sink; and
a second heat exchanger (120), having a part located in a second part of the volume and arranged in parallel with the first heat exchanger, the second heat exchanger being configured to transfer heat from a second portion of the inner coolant to the second heat sink.

4. The cooling apparatus of claim 3, wherein the first heat exchanger comprises a first conduction surface (71) that cooperates with the housing so as to define at least part of the volume.

5. The cooling apparatus of claim 4, wherein the second heat exchanger comprises a second conduction surface (171) that cooperates with the housing so as to define at least part of the volume.

6. The cooling apparatus of claim 5, wherein the housing and the first and second conduction surfaces define the volume.

7. The cooling apparatus of claim 6, wherein the housing, the first and second conduction surfaces and the electronic device define the volume.

8. The cooling apparatus of claim 7, wherein the volume further comprises a wicking material (305) such that a vapour chamber is formed.

9. The cooling apparatus of any of claims 6 to 8, further comprising the electronic device (75) having an axis of elongation and wherein the first (71) and second (171) conduction surfaces each have respective axes of elongation that are substantially parallel to the axis of elongation of the electronic device.

10. The cooling apparatus of claim 2, wherein the heat exchanger arrangement (410) further comprises:
a first piping system, arranged to carry the first outer coolant from the first coolant connector, to receive heat directly from the conduction surface and to transfer heat through the conduction surface to the first outer coolant; and
a second piping system, arranged in parallel with the first piping system to carry the second outer coolant from the second coolant connector, to receive heat directly from the conduction surface and to transfer heat through the conduction surface to the second outer coolant; and
wherein the first and second outer coolants are isolated from one another within the heat exchanger arrangement.

11. The cooling apparatus of claim 10, wherein the first piping system and second piping system are arranged in parallel in a helical arrangement.

12. A cooling system comprising at least one cooling apparatus in accordance with any preceding claim and further comprising:
a piping system, configured to carry the respective first outer coolant to each first coolant connector of the at least one cooling apparatus for acting as the first heat sink of the respective heat exchanger arrangement and to carry the respective second outer coolant to each second coolant connector of the at least one cooling apparatus for acting as the second heat sink of the respective heat exchanger arrangement; and
wherein, for each of the at least one cooling apparatus, the respective first and second outer coolants are isolated from one another within the piping system or wherein, for each of the at least one cooling apparatus, the piping system is configured to combine the respective first and second outer coolants.

13. The cooling system of claim 12, wherein the at least one cooling apparatus comprises a plurality of cooling apparatus, each cooling apparatus being in accordance with any one of claims 1 to 12 and wherein the first and second outer coolants are shared between each of the plurality of cooling apparatus.

14. The cooling system of claim 12 or claim 13, further comprising:
a second heat exchanger arrangement, configured to receive the respective first outer coolant and the respective second outer coolant from each of the at least one cooling apparatus and to transfer heat from the first and second outer coolants to a common output heat sink.

15. A method of operating a cooling system, comprising:
coupling an electronic device to an interfacing component of a cooling apparatus in the form of a module that defines a convective thermal interface through which heat generated by the electronic device can be transferred away from it via an inner coolant, the inner coolant comprising a liquid and the interfacing component comprising a housing (101) that defines at least part of a volume (102) in which at least part of the electronic device can be confined and which is filled by the inner coolant, such that the inner coolant provides the convective thermal interface;
operating the electronic device to generate heat that is transferred to the convective thermal interface;
receiving heat generated by the electronic device at a heat exchanger arrangement (110, 120) of the cooling apparatus via the convective thermal interface;
receiving a first outer coolant as part of a first heat sink at a first coolant connector, the first and second coolant connectors being configured to interface the module as part of a cooling system;
receiving a second outer coolant as part of the second heat sink at a second coolant connector;
transferring heat received at the heat exchanger arrangement to the first heat sink and the second heat sink, the first and second heat sinks being isolated from one another within the heat exchanger arrangement; and
in the event that a part of the heat exchanger arrangement is unable to transfer heat to the first heat sink, transferring at least some of the heat that would have been transferred to the first heat sink to the second heat sink.

## Patentansprüche

1. Kühlender Apparat (100) in der Form eines Moduls und umfassend:
eine Verknüpfungskomponente konfiguriert, um eine elektronische Vorrichtung aufzunehmen, und definierend eine konvektive thermale Schnittstelle durch welche durch die elektronische Vorrichtung erzeugte Wärme davon weg transferiert werden kann mittels eines inneren Kühlmittels, wobei das innere Kühlmittel eine Flüssigkeit umfasst und wobei die Verknüpfungskomponente ein Gehäuse (101) umfasst, das mindestens ein Teil eines Volumens (102) definiert, in dem mindestens ein Teil der elektronischen Vorrichtung eingeschlossen sein kann und welche durch das innere Kühlmittel gefüllt ist, so dass das innere Kühlmittel die konvektive thermale Schnittstelle bereitstellt;
**gekennzeichnet durch**
eine Wärmetauscheranordnung (110, 120), die an die konvektive thermale Schnittstelle gekoppelt ist und die ausgelegt ist, die durch die elektronische Vorrichtung erzeugte Wärme mittels der konvektiven thermalen Schnittstelle zu einer ersten Wärmesenke und einer zweiten Wärmesenke zu transferieren, wobei die erste und die zweite Wärmesenke voneinander innerhalb der Wärmetauscheranordnung isoliert sind, so dass in dem Fall, dass ein Teil der Wärmetauscheranordnung nicht in der Lage ist, Wärme zu der ersten Wärmesenke zu transferieren, die Wärmetauscheranordnung ausgelegt ist, wenigstens ein Teil der Wärme zu der zweiten Wärmesenke zu transferieren, die zu der ersten Wärmesenke transferiert worden wäre; und
wobei die Wärmetauscheranordnung umfasst: eine erste Kühlmittelverbindung zum Aufnehmen eines ersten äußeren Kühlmittels als Teil der ersten Wärmesenke; und eine zweite Kühlmittelverbindung zum Aufnehmen eines zweiten äußeren Kühlmittels als Teil der zweiten Wärmesenke, wobei die erste und die zweite Kühlmittelverbindung ausgelegt sind, das Modul als Teil eines kühlenden Systems zu verbinden.

2. Kühlender Apparat nach Anspruch 1, wobei die Wärmetauscheranordnung oder die Verknüpfungskomponente mindestens eine Leitungsfläche (71) umfasst, die ausgelegt ist, durch die elektronische Vorrichtung erzeugte Wärme mittels der konvektiven thermale Schnittstelle zu der ersten Wärmesenke und der zweiten Wärmesenke zu transferieren.

3. Kühlender Apparat nach Anspruch 1 oder Anspruch 2, wobei die Wärmetauscheranordnung umfasst:
einen ersten Wärmetauscher (110), der einen Teil aufweist lokalisiert in einem ersten Teil des Volumens und konfiguriert, um Wärme von einem ersten Bereich des inneren Kühlmittels zu der ersten Wärmesenke zu transferieren; und
einen zweiten Wärmetauscher (120), der einen Teil aufweist lokalisiert in einem zweiten Teil des Volumens und angeordnet parallel zu dem ersten Wärmetauscher, wobei der zweite Wärmetauscher konfiguriert ist, Wärme von einem zweiten Bereich des inneren Kühlmittels zu der zweiten Wärmesenke zu transferieren.

4. Kühlender Apparat nach Anspruch 3, wobei der erste Wärmetauscher eine erste Leitungsfläche (71) umfasst, die mit dem Gehäuse zusammenwirkt, um mindestens einen Teil des Volumens zu definieren.

5. Kühlender Apparat nach Anspruch 4, wobei der zweite Wärmetauscher eine zweite Leitungsfläche (171) umfasst, die mit dem Gehäuse zusammenwirkt, um mindestens einen Teil des Volumens zu definieren.

6. Kühlender Apparat nach Anspruch 5, wobei das Gehäuse und die erste und die zweite Leitungsfläche das Volumen definieren.

7. Kühlender Apparat nach Anspruch 6, wobei das Gehäuse, die erste und die zweite Leitungsfläche und die elektronische Vorrichtung das Volumen definieren.

8. Kühlender Apparat nach Anspruch 7, wobei das Volumen ferner ein Dochtstoffmaterial (305) umfasst, so dass eine Verdampfungskammer ausgebildet ist.

9. Kühlender Apparat nach irgend einem der Ansprüche 6 bis 8 ferner umfassend die elektronische Vorrichtung (75) aufweisend eine längliche Achse, wobei die erste (71) und die zweite (171) Leitungsfläche jeweils entsprechende längliche Achsen aufweisen, die im Wesentlichen parallel zu der länglichen Achse der elektronischen Vorrichtung sind.

10. Kühlender Apparat nach Anspruch 2, wobei die Wärmetauscheranordnung (410) ferner umfasst:
ein erstes Rohrsystem angeordnet, um das erste äußere Kühlmittel von der ersten Kühlmittelverbindung zu transportieren, um Wärme direkt von der Leitungsfläche aufzunehmen und um die Wärme durch die Leitungsfläche zu dem ersten äußeren Kühlmittel zu transferieren; und
ein zweites Rohrsystem angeordnet parallel zu dem ersten Rohrsystem, um das zweite äußere Kühlmittel von der zweiten äußeren Kühlmittelverbindung zu transportieren, um Wärme direkt von der Leitungsfläche aufzunehmen und um die Wärme durch die Leitungsfläche zu dem zweiten äußeren Kühlmittel zu transferieren; und
wobei das erste und das zweite äußere Kühlmittel voneinander innerhalb der Wärmetauscheranordnung isoliert sind.

11. Kühlender Apparat nach Anspruch 10, wobei das erste Rohrsystem und das zweite Rohrsystem parallel zueinander in einer schraubenförmigen Anordnung angeordnet sind.

12. Kühlendes System umfassend mindestens einen kühlenden Apparat in Übereinstimmung mit irgend einem vorhergehenden Anspruch und ferner umfassend:
ein Rohrsystem, das konfiguriert ist, entsprechend das jeweilige erste äußere Kühlmittel zu der jeweiligen ersten Kühlmittelverbindung des mindestens einen kühlenden Apparats zu transportieren zwecks Wirken als die erste Wärmesenke der entsprechenden Wärmetauscheranordnung bzw. entsprechend das jeweilige zweite äußere Kühlmittel zu der entsprechenden zweiten Kühlmittelverbindung des mindestens einen kühlenden Apparats zu transportieren zwecks Wirken als die zweite Wärmesenke der entsprechenden Wärmetauscheranordnung; und
wobei für jeden des mindestens einen Kühlapparats das entsprechende erste und zweite äußere Kühlmittel jeweils voneinander innerhalb des Rohrsystems isoliert sind oder wobei für jeden des mindestens einen Kühlapparats das Rohrsystem konfiguriert ist, die entsprechenden ersten und zweiten äußeren Kühlmittel zu kombinieren.

13. Kühlendes System nach Anspruch 12, wobei der mindestens eine kühlenden Apparat eine Mehrzahl von kühlenden Apparaten umfasst, wobei jeder kühlende Apparat in Übereinstimmung mit irgend einem der Ansprüche 1 bis 12 ist und wobei die ersten und zweiten äußeren Kühlmittel zwischen jeden der Mehrzahl von kühlenden Apparaten geteilt sind.

14. Kühlendes System nach Anspruch 12 oder Anspruch 13 ferner umfassend:
eine zweite Wärmetauscheranordnung konfiguriert zum Aufnehmen des entsprechenden ersten äußeren Kühlmittels und des entsprechenden zweiten äußeren Kühlmittel von jedem des mindestens einen kühlenden Apparats und zum Transferieren von Wärme von dem ersten und zweiten äußeren Kühlmittel zu einer gemeinsamen Ausgabewärmesenke.

15. Verfahren eines Betreibens eines kühlenden Systems umfassend:
Koppeln einer elektronischen Vorrichtung an eine Verknüpfungskomponente eines kühlenden Apparats in der Form eines Moduls, die eine konvektive thermale Schnittstelle definiert, durch welche durch die elektronische Vorrichtung erzeugte Wärme davon weg transferiert werden kann mittels eines inneren Kühlmittels, wobei das innere Kühlmittel eine Flüssigkeit umfasst und wobei die Verbindungskomponente ein Gehäuse (101) umfasst, das mindestens einen Teil eines Volumens (102) definiert, in dem mindestens ein Teil der elektronischen Vorrichtung eingeschlossen sein kann und das mit dem inneren Kühlmittel gefüllt ist, so dass das innere Kühlmittel die konvektive thermale Schnittstelle bereitstellt;
Betreiben der elektronischen Vorrichtung zum Erzeugen von Wärme, die zu der konvektiven thermalen Schnittstelle transferiert wird;
Aufnehmen von durch die elektronische Vorrichtung erzeugter Wärme an einer Wärmetauscheranordnung (110, 120) des kühlenden Apparats über die konvektive thermale Schnittstelle;
Aufnehmen eines ersten äußeren Kühlmittels als Teil einer ersten Wärmesenke an einer ersten Kühlmittelverbindung, wobei die erste und die zweite Kühlmittelverbindung konfiguriert sind, das Modul als Teil eines kühlenden Systems zu verbinden;
Aufnehmen eines zweiten äußeren Kühlmittels als Teil der zweiten Wärmesenke an einer zweiten Kühlmittelverbindung;
Transferieren von Wärme, die an der Wärmetauscheranordnung aufgenommen wurde, an die erste Wärmesenke und die zweite Wärmesenke, wobei die erste und die zweite Wärmesenke voneinander innerhalb der Wärmetauscheranordnung isoliert sind; und
in dem Fall, dass ein Teil der Wärmetauscheranordnung nicht in der Lage ist, Wärme zu der ersten Wärmesenke zu transferieren, Transferieren von mindestens etwas der Wärme, die zu der ersten Wärmesenke transferiert worden wäre, zu der zweiten Wärmesenke.

## Revendications

1. Appareil de refroidissement (100) se présentant sous la forme d'un module, comprenant :
un composant d'interfaçage configuré pour recevoir un dispositif électronique et définissant une interface thermique convective à travers laquelle la chaleur générée par le dispositif électronique peut être transférée loin de celui-ci par l'intermédiaire d'un fluide de refroidissement interne, le fluide de refroidissement interne comprenant un liquide et le composant d'interfaçage comprenant un boîtier (101) qui définit au moins une partie d'un volume (102) dans lequel au moins une partie du dispositif électronique peut être confinée et qui est rempli du fluide de refroidissement interne, de sorte que le fluide de refroidissement interne assure l'interface thermique convective ;
**caractérisé par**
un agencement d'échangeur de chaleur (110, 120), couplé à l'interface thermique convective et configuré pour transférer la chaleur générée par le dispositif électronique par l'intermédiaire de l'interface thermique convective à un premier dissipateur thermique et à un deuxième dissipateur thermique, les premier et deuxième dissipateurs thermiques étant isolés l'un de l'autre à l'intérieur de l'agencement d'échangeur de chaleur, de sorte que, dans le cas où une partie de l'agencement d'échangeur de chaleur ne peut pas transférer de la chaleur au premier dissipateur thermique, l'agencement d'échangeur de chaleur soit configuré pour transférer au moins une partie de la chaleur, qui aurait été transférée au premier dissipateur thermique, au deuxième dissipateur thermique ; et
où l'agencement d'échangeur de chaleur comprend : un premier connecteur de fluide de refroidissement, pour recevoir un premier fluide de refroidissement externe en tant que partie du premier dissipateur thermique ; et un deuxième connecteur de fluide de refroidissement, pour recevoir un deuxième fluide de refroidissement externe en tant que partie du deuxième dissipateur thermique, les premier et deuxième connecteurs de fluide de refroidissement étant configurés pour établir une interface avec le module en tant que partie d'un système de refroidissement.

2. Appareil de refroidissement de la revendication 1, dans lequel l'agencement d'échangeur de chaleur ou le composant d'interfaçage comprend au moins une surface de conduction (71), configurée pour transférer la chaleur générée par le dispositif électronique par l'intermédiaire de l'interface thermique convective au premier dissipateur thermique et au deuxième dissipateur thermique.

3. Appareil de refroidissement de la revendication 1 ou 2, dans lequel l'agencement d'échangeur de chaleur comprend :
un premier échangeur de chaleur (110), ayant une partie située dans une première partie du volume et configurée pour transférer de la chaleur d'une première partie du fluide de refroidissement interne au premier dissipateur thermique ; et
un deuxième échangeur de chaleur (120), ayant une partie située dans une deuxième partie du volume et agencée en parallèle avec le premier échangeur de chaleur, le deuxième échangeur de chaleur étant configuré pour transférer de la chaleur d'une deuxième partie du fluide de refroidissement interne au deuxième dissipateur thermique.

4. Appareil de refroidissement de la revendication 3, dans lequel le premier échangeur de chaleur comprend une première surface de conduction (71) qui coopère avec le boîtier de manière à définir au moins une partie du volume.

5. Appareil de refroidissement de la revendication 4, dans lequel le deuxième échangeur de chaleur comprend une deuxième surface de conduction (171) qui coopère avec le boîtier de manière à définir au moins une partie du volume.

6. Appareil de refroidissement de la revendication 5, dans lequel le boîtier et les première et deuxième surfaces de conduction définissent le volume.

7. Appareil de refroidissement de la revendication 6, dans lequel le boîtier, les première et deuxième surfaces de conduction et le dispositif électronique définissent le volume.

8. Appareil de refroidissement de la revendication 7, dans lequel le volume comprend en outre un matériau à effet de mèche (305) de sorte qu'une chambre à vapeur soit formée.

9. Appareil de refroidissement de l'une des revendications 6 à 8, comprenant en outre le dispositif électronique (75) ayant un axe d'allongement et dans lequel les première (71) et deuxième (171) surfaces de conduction ont chacune des axes d'allongement respectifs qui sont essentiellement parallèles à l'axe d'allongement du dispositif électronique.

10. Appareil de refroidissement de la revendication 2, dans lequel l'agencement d'échangeur de chaleur (410) comprend en outre :
un premier système de tuyauterie, agencé pour transporter le premier fluide de refroidissement externe à partir du premier connecteur de fluide de refroidissement, pour recevoir de la chaleur directement à partir de la surface de conduction et pour transférer de la chaleur à travers la surface de conduction au premier fluide de refroidissement externe ; et
un deuxième système de tuyauterie, agencé en parallèle avec le premier système de tuyauterie pour transporter le deuxième fluide de refroidissement externe à partir du deuxième connecteur de fluide de refroidissement, pour recevoir de la chaleur directement à partir de la deuxième surface de conduction et pour transférer de la chaleur à travers la surface de conduction au deuxième fluide de refroidissement externe ; et
où les premier et deuxième fluides de refroidissement externes sont isolés l'un de l'autre à l'intérieur de l'agencement d'échangeur de chaleur.

11. Appareil de refroidissement de la revendication 10, dans lequel le premier système de tuyauterie et le deuxième système de tuyauterie sont agencés en parallèle dans un agencement hélicoïdal.

12. Système de refroidissement comprenant au moins un appareil de refroidissement conforme à l'une des revendications précédentes et comprenant en outre :
un système de tuyauterie, configuré pour transporter le premier fluide de refroidissement externe respectif à chaque premier connecteur de fluide de refroidissement de l'au moins un appareil de refroidissement pour agir en tant que premier dissipateur thermique de l'agencement d'échangeur de chaleur respectif et pour transporter le deuxième fluide de refroidissement externe respectif à chaque deuxième connecteur de fluide de refroidissement de l'au moins un appareil de refroidissement pour agir en tant que deuxième dissipateur thermique de l'agencement d'échangeur de chaleur respectif ; et
dans lequel, pour chacun de l'au moins un appareil de refroidissement, les premier et deuxième fluides de refroidissement externes respectifs sont isolés l'un de l'autre à l'intérieur du système de tuyauterie ou dans lequel, pour chacun de l'au moins un appareil de refroidissement, le système de tuyauterie est configuré pour combiner les premier et deuxième fluides de refroidissement externes respectifs.

13. Système de refroidissement de la revendication 12, dans lequel l'au moins un appareil de refroidissement comprend une pluralité d'appareils de refroidissement, chaque appareil de refroidissement étant conforme à l'une quelconque des revendications 1 à 12 et dans lequel les premier et deuxième fluides de refroidissement externes sont partagés entre chacun de la pluralité d'appareils de refroidissement.

14. Système de refroidissement de la revendication 12 ou 13, comprenant en outre :
un deuxième agencement d'échangeur de chaleur, configuré pour recevoir le premier fluide de refroidissement externe respectif et le deuxième fluide de refroidissement externe respectif à partir de chacun de l'au moins un appareil de refroidissement et pour transférer la chaleur provenant des premier et deuxième fluides de refroidissement externes à un dissipateur thermique de sortie commun.

15. Procédé de fonctionnement d'un système de refroidissement, comprenant les étapes qui consistent :
à coupler un dispositif électronique à un composant d'interfaçage d'un appareil de refroidissement se présentant sous la forme d'un module qui définit une interface thermique convective à travers laquelle la chaleur générée par le dispositif électronique peut être transférée loin de celui-ci par l'intermédiaire d'un fluide de refroidissement interne, le fluide de refroidissement interne comprenant un liquide et le composant d'interfaçage comprenant un boîtier (101) qui définit au moins une partie d'un volume (102) dans lequel au moins une partie du dispositif électronique peut être confinée et qui est rempli du fluide de refroidissement interne, de sorte que le fluide de refroidissement interne assure l'interface thermique convective ;
à faire fonctionner le dispositif électronique pour générer de la chaleur qui est transférée à l'interface thermique convective ;
à recevoir la chaleur générée par le dispositif électronique au niveau d'un agencement d'échangeur de chaleur (110, 120) de l'appareil de refroidissement par l'intermédiaire de l'interface thermique convective ;
à recevoir un premier fluide de refroidissement externe en tant que partie d'un premier dissipateur thermique au niveau d'un premier connecteur de fluide de refroidissement, les premier et deuxième connecteurs de fluide de refroidissement étant configurés pour établir une interface avec le module en tant que partie d'un système de refroidissement ;
à recevoir un deuxième fluide de refroidissement externe en tant que partie du deuxième dissipateur thermique au niveau d'un deuxième connecteur de fluide de refroidissement ;
à transférer la chaleur reçue au niveau de l'agencement d'échangeur de chaleur au premier dissipateur thermique et au deuxième dissipateur thermique, les premier et deuxième dissipateurs thermiques étant isolés l'un de l'autre à l'intérieur de l'agencement d'échangeur de chaleur ; et
dans le cas où une partie de l'agencement d'échangeur de chaleur ne peut pas transférer de la chaleur au premier dissipateur thermique, à transférer au moins une partie de la chaleur, qui aurait été transférée au premier dissipateur thermique, au deuxième dissipateur thermique.
